# EUROPÄISCHE PATENTANMELDUNG

(11) **EP 0 851 475 A2**
(43) Veröffentlichungstag der Anmeldung: **01.07.1998**
(21) Anmeldenummer: 97810919.7
(22) Anmeldetag: 27.11.1997
(51) Int. Cl.: H01L 21/331, H01L 29/739

(54) **Verfahren zum Herstellen eines MOS-gesteuerten Leistungshalbleiterbauelements**

(30) Priorität: 23.12.1996 DE 19654113
(71) Anmelder: Asea Brown Boveri AG, 5401 Baden (CH)
(72) Erfinder: Thiemann, Uwe, 79793 Wutöschingen (DE)
(74) Vertreter: Weibel, Beat

(57) **Zusammenfassung**

Die Erfindung betrifft ein Verfahren zum Herstellen eines MOS-gesteuerten Leistungshalbleiterbauelements (30), welches Leistungshalbleiterbauelement (30) in einem gemeinsamen Substrat (31) eine Mehrzahl von nebeneinander angeordneten, parallelgeschalteten Bauelementzellen umfasst. In jeder Bauelementzelle ist ein aus einem Kollektorgebiet (33) eines ersten Leitfähigkeitstyps, einem darüberliegenden Basisgebiet (32) eines zweiten Leitfähigkeitstyps, und einem von oben in das Basisgebiet (32) eingelassenen Emittergebiet (37) vom ersten Leitfähigkeitstyp gebildeter Bipolartransistor vorhanden. Auf der Emitterseite ist eine MOS-Kanal-Struktur (39, 42, 43) zur Steuerung des Bipolartransistors vorgesehen, welche MOS-Kanal-Struktur (39, 42, 43) ein oberhalb des Emittergebietes (37) liegendes Sourcegebiet (43) vom zweiten Leitfähigkeitstyp, ein randseitig am Emittergebiet (37) zwischen Sourcegebiet (43) und Basisgebiet (32) angeordnetes Kanalgebiet (42) vom ersten Leitfähigkeitstyp und eine über dem Kanalgebiet (42) isoliert angeordnete Gateelektrode (39) umfasst. Eine einfache Einstellung der Stromdichte im Kurzschlussfall und des Löcher-Bypass-Widerstandes ohne zusätzlichen Prozessaufwand wird dadurch erreicht, dass die MOS-Kanal-Struktur (39, 42, 43) in der Kanalweite strukturiert ist, und dass die Strukturierung der Kanalweite der MOS-Kanal-Struktur (39, 42, 43) indirekt durch einen der anderen im Herstellungsprozess des Bauelements verwendeten Maskenschritte erfolgt.

## Beschreibung

### TECHNISCHES GEBIET

Die vorliegende Erfindung bezieht sich auf das Gebiet der Leistungselektronik. Sie betrifft ein Verfahren zum Herstellen eines MOS-gesteuerten Leistungshalbleiterbauelements, welches Leistungshalbleiterbauelement in einem gemeinsamen Substrat eine Mehrzahl von nebeneinander angeordneten, parallelgeschalteten Bauelementzellen umfasst, wobei in jeder Bauelementzelle ein aus einem Kollektorgebiet eines ersten Leitfähigkeitstyps, einem darüberliegenden Basisgebiet eines zweiten Leitfähigkeitstyps, und einem von oben in das Basisgebiet eingelassenen Emittergebiet vom ersten Leitfähigkeitstyp gebildeter Bipolartransistor vorhanden ist, und wobei auf der Emitterseite eine MOS-Kanal-Struktur zur Steuerung des Bipolartransistors vorgesehen ist, welche MOS-Kanal-Struktur ein oberhalb des Emittergebietes liegendes Sourcegebiet vom zweiten Leitfähigkeitstyp, ein randseitig am Emittergebiet zwischen Sourcegebiet und Basisgebiet angeordnetes Kanalgebiet vom ersten Leitfähigkeitstyp und eine über dem Kanalgebiet isoliert angeordnete Gateelektrode umfasst.

### STAND DER TECHNIK

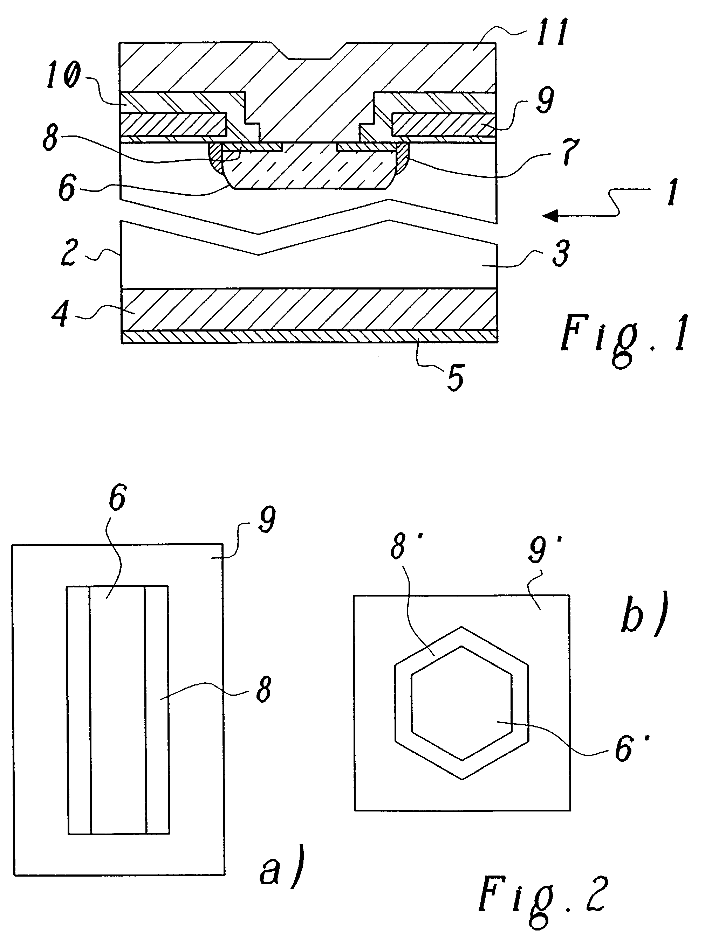

Heutige MOS-gesteuerte Leistungshalbleiterbauelemente von der Art der IGBTs (Insulated Gate Bipolar Transistors) bestehen aus einer Vielzahl gleicher, parallelgeschalteter Bauelementzellen, die nebeneinander in einem gemeinsamen Halbleitersubstrat untergebracht sind. In jeder der Bauelementzellen eines solchen Leistungshalbleiterbauelements 1, von denen eine beispielhaft in Fig. 1 im Querschnitt wiedergegeben ist, ist innerhalb des Substrats 2 ein Bipolartransistor untergebracht, der ein (P⁺-dotiertes) Kollektorgebiet 4, ein (N-do-tiertes) Basisgebiet 3 und ein (P⁺-dotiertes) Emittergebiet 6 umfasst. Auf der Emitterseite des IGBT wird eine MOS-Kanal-Struktur der Zelle, welche ein (P-dotiertes) Kanalgebiet 7, ein (N⁺-dotiertes) Sourcegebiet 8 und eine über dem Kanalgebiet 7 isoliert angeordnete (Poly-Si-)Gateelektrode 9 umfasst, dazu verwendet, um den Basisstrom des integrierten Bipolartransistors zu steuern.

Das Kanalgebiet 7 verbindet dazu das Sourcegebiet 8 mit dem Basisgebiet 3, d.h., der Basis des Bipolartransistors. Das Basisgebiet 3 ist Teil einer durchgehenden Basisschicht. Das Kollektorgebiet 4 ist Teil einer durchgehenden Kollektorschicht. Die Gateelektrode 9 ist durch ein Oxid 10 von dem darunterliegenden Substrat 2 und der darüberliegenden Metallisierung des Emitterkontakts 11 isoliert. Der Emitterkontakt kontaktiert gleichzeitig das Emittergebiet 6 und das Sourcegebiet 8. Zur kollektorseitigen Kontaktierung des IGBTs ist auf der Unterseite des Substrats 2 eine Kollektormetallisierung 5 vorgesehen.

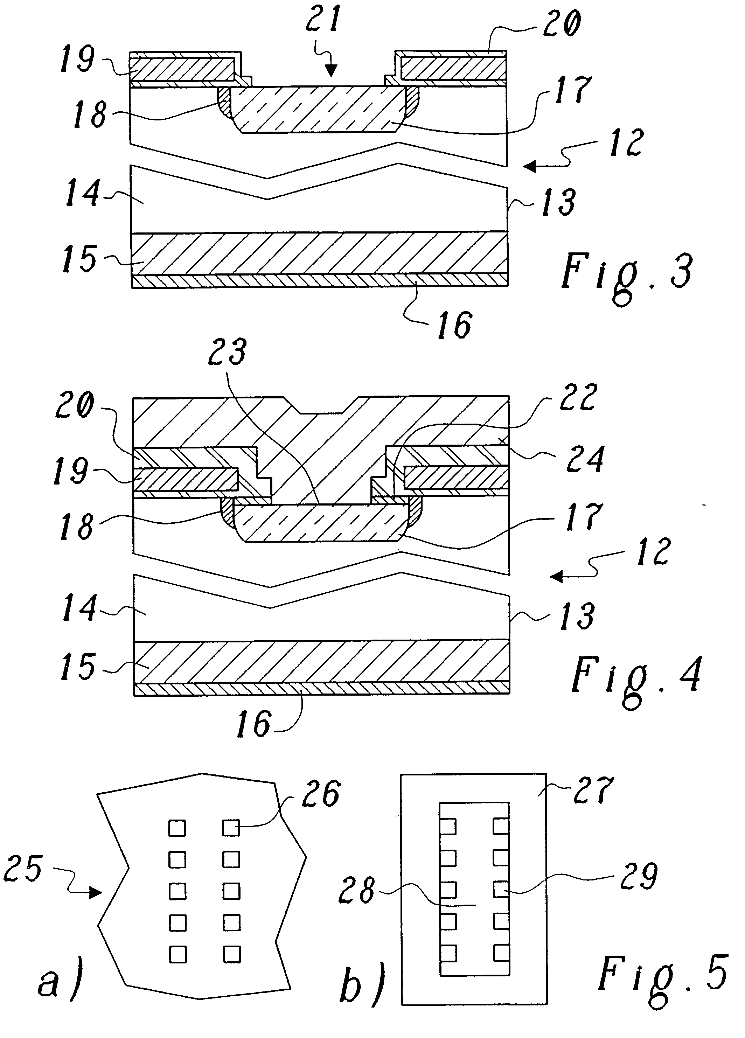

Die laterale Ausdehnung der Bauelementzellen kann unterschiedlichen Geometrien folgen. Zwei Beispiele von heute bekannten und eingesetzten Zellgeometrien sind in Fig. 2(a) und (b) in der Draufsicht von oben wiedergegeben. Fig. 2(a) zeigt eine Streifenstruktur mit einem länglichen Emittergebiet 6, welches auf den beiden Längsseiten von zwei streifenförmigen Sourcegebieten 8 überlagert und insgesamt von der Gateelektrode 9 umgeben ist. Fig. 2(b) zeigt eine polygonale (in diesem Fall hexagonale) Zellenstruktur, bei der ein zentrales polygonales Emittergebiet 6' randseitig von einem durchgehenden, ringförmigen Sourcegebiet 8' überdeckt und von einer Gateelektrode 9' umschlossen ist. In beiden Beispielen ist der Emitterkontakt weggelassen.

Eine Problemstellung beim IGBT ist die sog. Latch-Up-Festigkeit (Einrastfestigkeit) der Bauelemente: Ist der Löcherstrom des Bipolartransistors zu hoch, kann es zum Zünden des durch das Sourcegebiet 8, das Emittergebiet 6, das Basisgebiet 3 und das Kollektorgebiet 4 gebildeten, parasitären Thyristors kommen. Weiterhin kann im Kurzschlussfall die Leistungsdichte im Bereich der MOS-Kanal-Struktur so hoch werden, dass eine thermische Zerstörung des Bauelements auftritt. Deshalb ist es grundsätzlich erstrebenswert, den Kurzschlussstrom zu begrenzen (Leistungsbegrenzung im Kurzschlussfall) und zusätzlich den Löcher-Bypass-Widerstand um das Sourcegebiet 8 herum so gering wie möglich zu halten (Reduktion der Latch-Up-Empfindlichkeit). Diese Massnahmen sollten mit möglichst wenig zusätzlichem prozesstechnischem Aufwand (Kosten) erreicht werden.

In einigen IGBTs werden heutzutage uniforme Sourcegebiete verwendet, was die Einsparung einer Maske bedeutet: Die Implantation der (N⁺-)Sourcegebiete erfolgt maskenlos. Ausserhalb der aktiven Bauelementfläche wird die Implantation durch ein Dickoxid maskiert. Während der Kontaktlochätzung wird dann zusätzlich in die oberste Siliziumschicht geätzt und die N⁺-Schicht wieder entfernt. Es entsteht ein lateraler Kontakt zum Sourcegebiet am Rand des Kontaktlochfensters.

Eine solche maskenlose Sourcegebiet-Implantation ist in den Fig. 3 und 4 im Querschnitt durch eine Bauelementzelle eines Leistungshalbleiterbauelements 12 wiedergegeben: Bei diesem Bauelement wird in das N-dotierte Substrat 13, welches zugleich das Basisgebiet 14 bildet, zunächst von unten ein Kollektorgebiet (eine Kollektorschicht) 15 eingebracht. Weiter werden von oben - durch ein Fenster 21 und maskiert durch die spätere Gateelektrode 19 - ein Emittergebiet 17 und die Kanalgebiete 18 eingebracht. Anschliessend wird, maskiert durch die Gateelektrode 19, ein Sourcegebiet 22 implantiert, von dem der Mittelbereich zur Schaffung eines Kontaktloches 23 weggeätzt wird (Fig. 4). Durch das Kontaktloch 23 kontaktiert ein Emitterkontakt 24 sowohl das Emittergebiet 17 als auch die Sourcegebiete 22. Die kollektorseitige Kontaktierung erfolgt durch eine Kollektormetallisierung 16.

Nachteil dieser Technik ist, dass die N⁺-Schicht bzw. das Sourcegebiet 22 entlang der Kante der Poly-Si-Gateelektrode, d.h., entlang der Kante des Kontaktloches 23, nicht strukturiert wird. Damit ergibt sich für die MOS-Kanal-Struktur eine grosse Kanalweite (Bereich, über welche der Kanal wirksam ist), wodurch die Leistungsdichte pro IGBT-Zelle im Kurzschlussfall sehr gross wird.

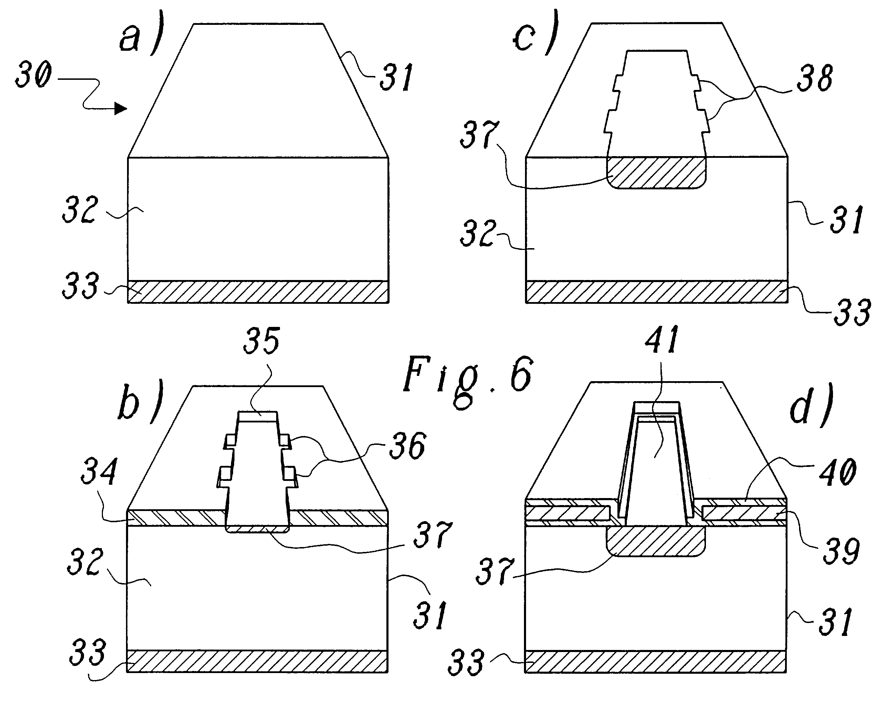

Bei anderen bekannten IGBT-Typen wird eine separate Photolackmaske für die Implantation des Sourcegebietes 22 verwendet. Eine solche Maske 25, wie sie für eine Zellengeometrie gemäss Fig. 2(a) geeignet ist, ist ausschnittweise in Fig. 5(a) in der Draufsicht wiedergegeben. In dieser Maske 25 sind in zwei Reihen kleine Maskenöffnungen 26 vorgesehen, durch welche die N⁺-Implantation erfolgt. Die resultierende Zellenstruktur hat - im Vergleich zu Fig. 2(a) - die in Fig. 5(b) gezeigte Anordnung von Gatebereich 27, Emittergebiet 28 und inselförmigen Sourcegebieten 29. Damit kann, allerdings auf Kosten steigender Prozesskomplexität, die Kanalweite und damit die Leistungsdichte im Kurzschlussfall per Design (vor allem der Sourcegebiete) eingestellt werden. Ein weiterer Vorteil dieser Methode ist, dass durch die laterale Begrenzung des N⁺-Sourcegebietes ein Löcher-Bypass geschaffen wird, der die Latch-Up-Empfindlichkeit des Bauelements verringert. Wie bereits erwähnt, ist für diese Lösung jedoch wenigstens ein zusätzlicher Maskenschritt erforderlich, der den Herstellungsprozess in unerwünschter Weise verkompliziert.

### DARSTELLUNG DER ERFINDUNG

Es ist nun Aufgabe der Erfindung, ein Verfahren zur Herstellung eines Leistungs-IGBT-Bauelements anzugeben, welches es mit geringem zusätzlichem Prozessaufwand erlaubt, einen IGBT mit Leistungsbegrenzung im Kurzschlussfall und einem reduzierten Löcher-Bypass-Widerstand erzeugen.

Die Aufgabe wird bei einem Verfahren der eingangs genannten Art dadurch gelöst, dass die MOS-Kanal-Struktur in der Kanalweite strukturiert ist, und dass die Strukturierung der Kanalweite der MOS-Kanal-Struktur indirekt durch einen der anderen im Herstellungsprozess des Bauelements verwendeten Maskenschritte erfolgt. Durch die Strukturierung der Kanalweite der MOS-Kanal-Struktur lässt sich die Kanalweite und damit die Leistung im Kurzschlussfall und der Löcher-Bypass-Widerstand auf die gewünschten Werte einstellen. Durch Verwendung eines im Prozess bereits vorhandenen Maskenschrittes entfällt der Einsatz einer speziellen zusätzlichen Maske für diese Strukturierung.

Eine erste bevorzugte Ausführungsform des erfindungsgemässen Verfahrens ist dadurch gekennzeichnet, dass zur Strukturierung der Kanalweite der MOS-Kanal-Struktur derjenige Maskenschritt verwendet wird, mit welchem das Emittergebiet in das Substrat eingebracht wird, dass für den Maskenschritt, mit welchem das Emittergebiet in das Substrat eingebracht wird, eine Maske verwendet wird, welche randseitig um eine Maskenöffnung herum angeordnete, seitlich nach aussen sich erstreckende Aussparungen aufweist, derart, dass das eingebrachte Emittergebiet im Gebiet der Aussparungen seitlich nach aussen sich erstreckende Finger aufweist, und dass die Länge der Finger so gewählt wird, dass sie zumindest über das später eingebrachte Sourcegebiet seitlich hinausragen. Durch die Finger wird auf einfache Weise gezielt und lokal die Ausbildung eines Steuerungskanals unter Betriebsbedingungen verhindert. Durch Breite, Tiefe und Anzahl der Finger können sowohl die Höhe des Sättigungsstromes (Leistungsdichte im Kurzschlussfall) als auch der Löcher-Bypass-Widerstand einfach und sicher eingestellt werden.

Eine zweite bevorzugte Ausführungsform des erfindungsgemässen Verfahrens zeichnet sich dadurch aus, dass auf der Oberseite des Substrats zwischen den Bauelementzellen eine Feldoxidschicht angeordnet ist, dass zur Strukturierung der Kanalweite der MOS-Kanal-Struktur derjenige Maskenschritt verwendet wird, mit welchem die Feldoxidschicht auf dem Substrat strukturiert wird, dass für den Maskenschritt, mit welchem die Feldoxidschicht auf dem Substrat strukturiert wird, eine Maske verwendet wird, welche vom Rand des die Bauelementzelle abdeckenden Maskengebiets ausgehende und nach innen sich erstreckende erste Finger aufweist, derart, dass die aufgebrachte Feldoxidschicht, welche die Bauelementzellen umgibt, im Gebiet der Aussparungen nach innen sich erstreckende zweite Finger aufweist, welche bei dem nachfolgenden Einbringen des Sourcegebietes eine Ausbildung des Sourcegebietes in ihrem Bereich verhindern bzw. maskieren. Auch in diesem Fall können durch Breite, Tiefe und Anzahl der zweiten Finger sowohl die Höhe des Sättigungsstromes als auch der Löcher-Bypass-Widerstand einfach und sicher eingestellt werden.

Eine weitere bevorzugte Ausführungsform des erfindungsgemässen Verfahrens ist dadurch gekennzeichnet, dass zur Strukturierung der Kanalweite der MOS-Kanal-Struktur derjenige Maskenschritt verwendet wird, mit welchem die Gateelektrode auf dem Substrat strukturiert wird, dass für den Maskenschritt, mit welchem die Gateelektrode auf dem Substrat strukturiert wird, eine Maske verwendet wird, welche vom Rand des die Bauelementzelle umgebenden Maskengebiets ausgehende und nach innen sich erstreckende erste Finger aufweist, derart, dass die aufgebrachte Gateelektrode im Gebiet der Aussparungen nach innen sich erstreckende zweite Finger aufweist, welche bei dem nachfolgenden Einbringen des Sourcegebietes die Ausbildung einer Kanalstruktur in ihrem Bereich verhindern bzw. maskieren. Auch in diesem Fall wird über die Geometrie der zweiten Finger die Einstellung der gewünschten Parameter vorgenommen.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: im Querschnitt die Bauelementzelle eines bekannten Leistungs-IGBT;
- Fig. 2: in der Draufsicht zwei bekannte Geometrien einer Bauelementzelle nach Fig. 1
- Fig. 3: die selbstjustierende Implantation von Emittergebiet und Kanalgebiet bei einer bekannten IGBT-Zelle;
- Fig. 4: die Implantation und Kontaktierung der Sourcegebiete bei der Zelle nach Fig. 3;
- Fig. 5: eine Maske (a) für die bekannte Strukturierung des Sourcegebietes und die resultierende Geometrie der IGBT-Zelle (b);
- Fig. 6: verschiedene Schritte bei der Herstellung eines IGBT gemäss einem ersten bevorzugten Ausführungsbeispiel des erfindungsgemässen Verfahrens, bei welchem zur Strukturierung der MOS-Kanal-Struktur das Emittergebiet strukturiert wird;
- Fig. 7: verschiedene Schritte bei der Herstellung eines IGBT gemäss einem zweiten bevorzugten Ausführungsbeispiel des erfindungsgemässen Verfahrens, bei welchem zur Strukturierung der MOS-Kanal-Struktur die Feldoxidschicht strukturiert wird; und
- Fig. 8: in der Draufsicht die Geometrie einer IGBT-Zelle, welche gemäss einem dritten bevorzugten Ausführungsbeispiel des Verfahren nach der Erfindung hergestellt worden ist, wobei zur Strukturierung der MOS-Kanal-Struktur die Poly-Si-Gateelektrode strukturiert wird.

### WEGE ZUR AUSFÜHRUNG DER ERFINDUNG

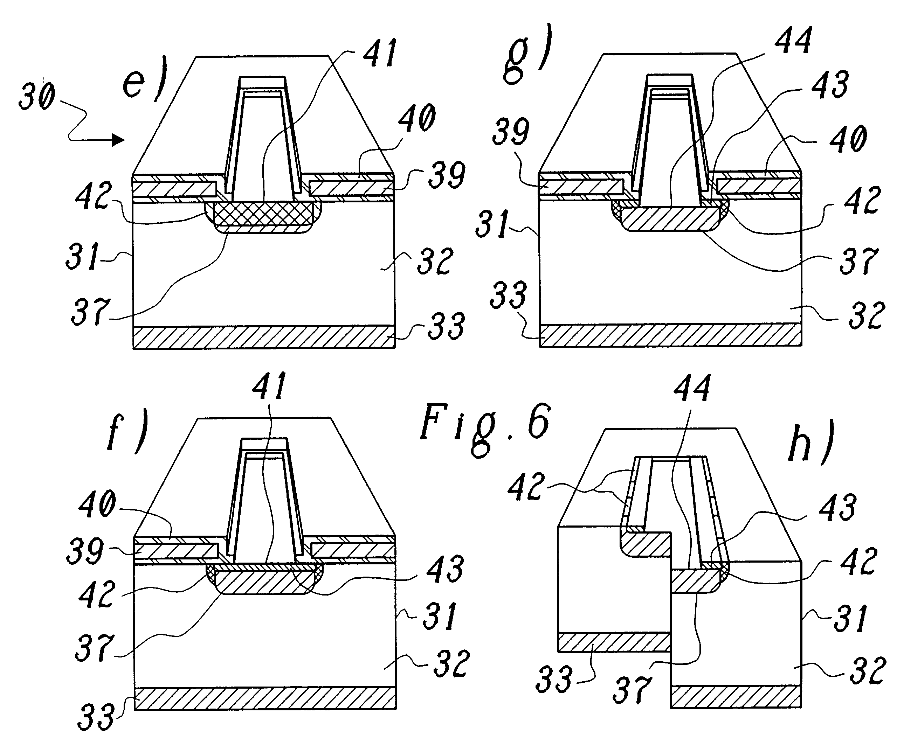

Ein erstes bevorzugtes Ausführungsbeispiel des erfindungsgemässen Verfahrens ist in verschiedenen Prozessschritten in Fig. 6 wiedergegeben, wobei eine einzelne (herzustellende) IGBT-Zelle in perspektivischer, geschnittener Darstellung gezeigt ist. Der Prozess für die Herstellung des MOS-gesteuerten Leistungshalbleiterbauelements 30 geht aus von einem (Si-)Substrat 31, welches beispielsweise N-dotiert ist. In das Substrat 31 ist von unten her ein P⁺-dotierte Schicht eingebracht, welche in der IGBT-Zelle das Kollektorgebiet 33 des IGBT-Transistors bildet. Das übrige Substrat bildet das Basisgebiet 32 (Fig. 6(a)).

Auf die Oberseite des Substrats 31 wird dann eine Maske 34 für die Implantation eines Emittergebietes 37 aufgebracht und ein P'-dotiertes Emittergebiet 37 durch eine Maskenöffnung 35 in der Maske 34 implantiert (Fig. 6(b)). Die Besonderheit der Maske 34 besteht im Zusammenhang mit der Erfindung darin, dass sie randseitig um die Maskenöffnung 35 herum angeordnete, seitlich nach aussen sich erstreckende Aussparungen 36 aufweist. Hierdurch wird bewirkt, dass das eingebrachte Emittergebiet 37 im Gebiet der Aussparungen 36 seitlich nach aussen sich erstreckende Finger 38 aufweist (Fig. 6(c)). Die Länge der Finger 38 wird dabei so gewählt, dass sie - wie nachfolgend noch erläutert wird - nach Prozessende zumindest über das später eingebrachte Sourcegebiet seitlich hinausragen.

Nachdem die Implantation des streifenförmigen Emittergebietes 37 abgeschlossen und die Maske 34 entfernt ist, wird auf die Oberseite des Substrats 31 die von einem Oxid 40 umgebende Gateelektrode 39 aus Poly-Silizium aufgebracht und strukturiert. Dabei wird ein über dem Emittergebiet 37 zentral angeordnetes Fenster 41 geöffnet (Fig. 6(d). Durch das Fenster 41 hindurch werden nacheinander in das Substrat 31 ein P-dotiertes Kanalgebiet 42 (Fig. 6(e)) und eine N⁺-dotiertes flaches Sourcegebiet 43 (Fig. 6(f)) implantiert. Schliesslich wird im Bereich des Fensters 41 noch die obere Schicht des Substrats 31 mit dem implantierten Sourcegebiet 43 weggeätzt (Fig. 6(g)), so dass sowohl das Emittergebiet 37 als auch die Sourcegebiete 43 von einer darüber aufgebrachten Metallisierung kontaktiert werden können.

Das Kanalgebiet 42 wird soweit eindiffundiert, dass es in den Bereichen des Emittergebietes 37, in denen keine Finger 38 vorhanden sind, seitlich über das Emittergebiet hinausragt und bis unter die Kante der Gateelektrode 39 reicht (Fig. 6(h)). Auf diese Weise steht das Sourcegebiet 43 über die Kanalgebiete 42 mit dem Basisgebiet 32 in Verbindung und bildet zusammen mit der darüberliegenden Gatelektrode die MOS-Kanal-Struktur zur Steuerung des IGBT-Transistors. In den Bereichen dagegen, in denen das Emittergebiet 37 durch die Finger 38 seitlich weiter ausgedehnt ist, werden die Sourcegebiete 43 ganz von dem Emittergebiet 37 umgeben. Die Schwellenspannung dieser Bereiche liegt dann über der verwendeten Gate-Emitter-Spannung, so dass diese Bereiche für die Steuerung des IGBT-Transistors ausfallen. Als Resultat ergibt sich eine MOS-Kanal-Struktur, bei der sich aktiv steuerbare Bereiche (ausserhalb der Finger 38) mit passiven Bereichen (innerhalb der Finger 38) abwechseln. Durch Breite, Tiefe und Anzahl (Wiederholrate) der Finger 38 können dann sowohl die Höhe des Sättigungsstromes (Leistungsdichte im Kurzschlussfall) als auch der Löcher-Bypass-Widerstand eingestellt werden. Die Finger 38 ragen dabei zumindest über die Sourcegebiete 43 seitlich hinaus. Sie können aber auch über die an die Sourcegebiete 43 seitlich angrenzenden Kanalgebiete 42 seitlich hinausragen.

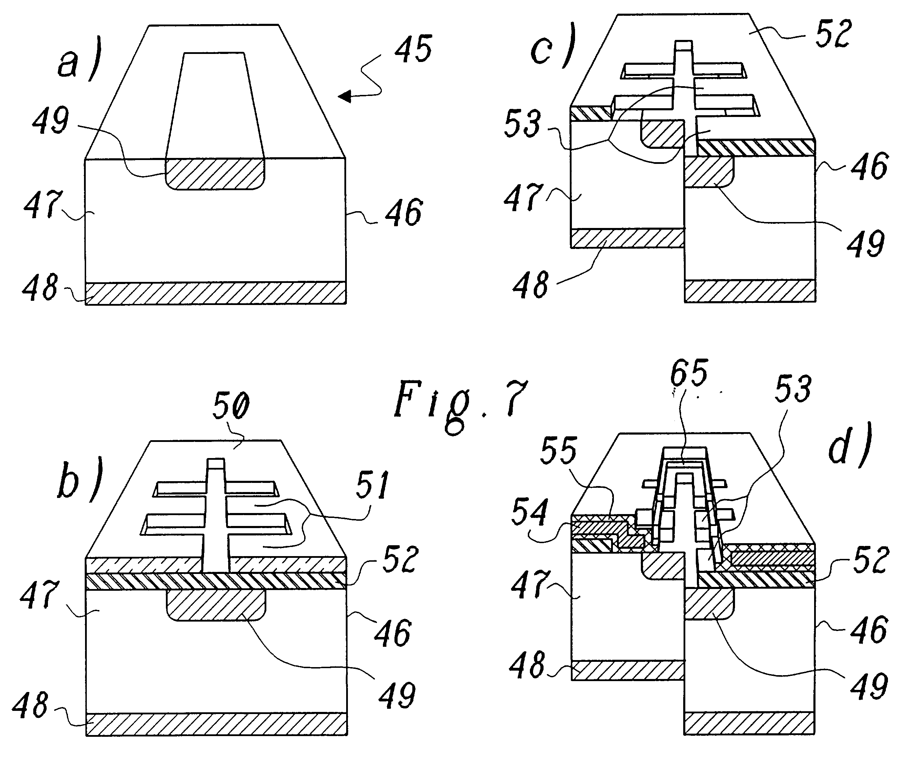

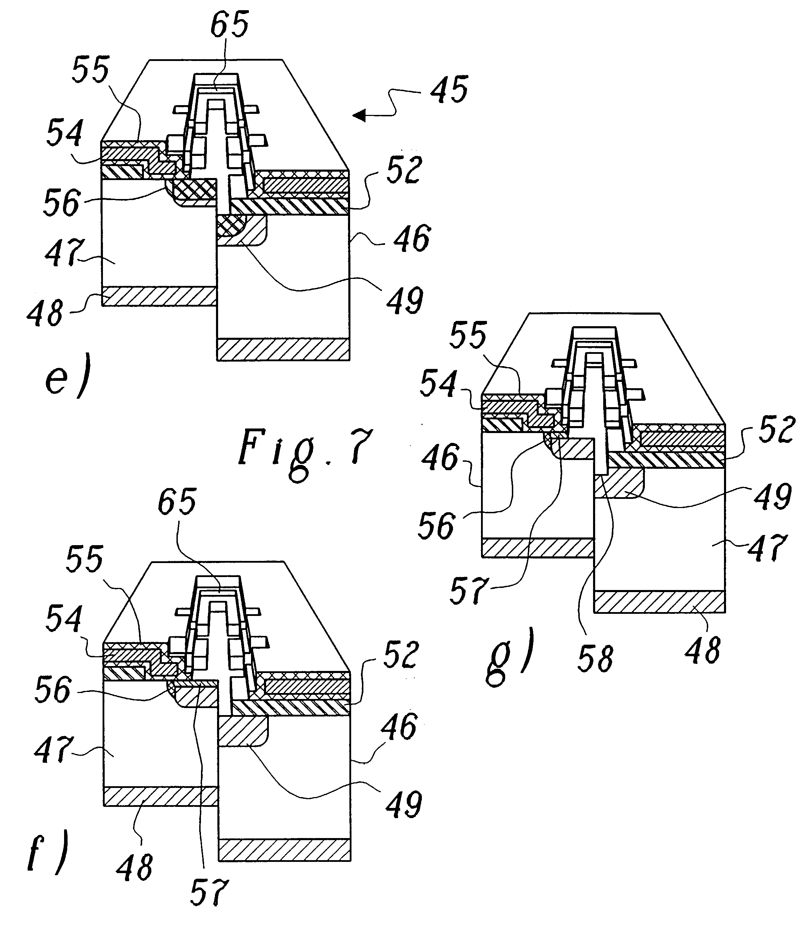

Fig. 7 zeigt eine zu Fig. 6 vergleichbare Prozessfolge für ein weiteres bevorzugtes Ausführungsbeispiel des Verfahrens nach der Erfindung. Das Verfahren für die Herstellung eines MOS-gesteuerten Leistungshalbleiterbauelements 45 geht aus von einem Substrat 46 mit Basisgebiet (N-dotiert) Kollektorgebiet 48 (P⁺-dotiert) und einem bereits implantierten, streifenförmigen P⁺-Emittergebiet 49 (Fig. 7(a).

Im vorliegenden Fall von Hochleistungs-IGBTs ist der Abstand zwischen zwei Bauelementzellen, von denen eine in Fig. 7 betrachtet wird, so gross, dass (dicke) Feldoxide verwendet werden können, um die gesamte Dünnoxidfläche so klein wie möglich zu halten (Eingangskapazität, Ausbeute). Zum Strukturieren einer vorher ganzflächig aufgebrachten Feldoxidschicht 52 auf dem Substrat 46 zwischen den IGBT-Zellen wird eine Maske benötigt, die grundsätzlich den Bereich der Zellen freilässt, den Bereich zwischen den Zellen jedoch abdeckt. Eine solche Maske 50 wird in modifizierter Form auf die Oberseite des Substrats 46 aufgebracht (Fig. 7(b)). Die Modifizierung besteht darin, dass die Maske 50 vom Rand des die Bauelementzelle umgebenden Maskengebiets ausgehende und nach innen sich erstreckende erste Finger 51 aufweist. Wird anschliessend die Feldoxidschicht 52 geätzt, hat diese Feldoxidschicht 52 im Gebiet der ersten Finger 51 nach innen sich erstreckende zweite Finger 53 (Fig. 7(c)). Diese zweiten Finger 53 reichen über den Rand des Emittergebietes 49 hinaus nach innen (rechte Schnitthälfte in Fig. 7(c)), während ausserhalb der zweiten Finger 53 die Feldoxidschicht 52 bereits weit vor dem Emittergebiet 49 endet (linke Schnitthälfte von Fig. 7(c)).

Bei dem nachfolgenden Einbringen des Sourcegebietes in das Substrat wird durch die zweiten Finger 53 eine Ausbildung des Sourcegebietes in ihrem Bereich verhindert bzw. maskiert: Zum Implantieren des Kanalgebietes und des Sourcegebietes wird wiederum - wie in Fig. 6(d-f) - auf das Substrat 46 und über der Feldoxidschicht 52 eine von einem Oxid 55 umgebene strukturierte Gateelektrode 54 (aus Poly-Si) aufgebracht, die im Bereich der Bauelement-Zelle ein streifenförmiges Fenster 65 aufweist (Fig. 7(d)). Aufgrund ihrer Länge ragen die zweiten Finger 53 der Feldoxidschicht 52 teilweise in die Oeffnung des Fensters 65 hinein.

Durch das Fenster 65 hindurch werden nacheinander das P-dotierte Kanalgebiet 56 (Fig. 7(e)) und das N⁺-dotierte Sourcegebiet 57 (Fig. 7(f)) implantiert. Die in das Fenster 65 hineinragenden Finger 53 verhindern dabei die Ausbildung einer MOS-Kanal-Struktur im Fingerbereich. Schliesslich wird wiederum der zentrale Bereich des Sourcegebietes 57 ausgeätzt, um durch das entstehende Kontaktloch 58 eine Kontaktierung des Emittergebietes 49 zu ermöglichen (Fig. 7(g)). Bei der fertigen Zelle wechseln sich auch hier wieder aktiv steuerbare Bereiche (ausserhalb der zweiten Finger 53, linke Querschnittshälfte in Fig. 7(g)) mit passiven Bereichen (unterhalb der zweiten Finger 53; rechte Querschnittshälfte in Fig. 7(g)) ab. Durch Breite und Anzahl (Wiederholrate) der zweiten Finger 53 kann dann die Kanalweite und damit die Kurzschlussstromdichte eingestellt werden.

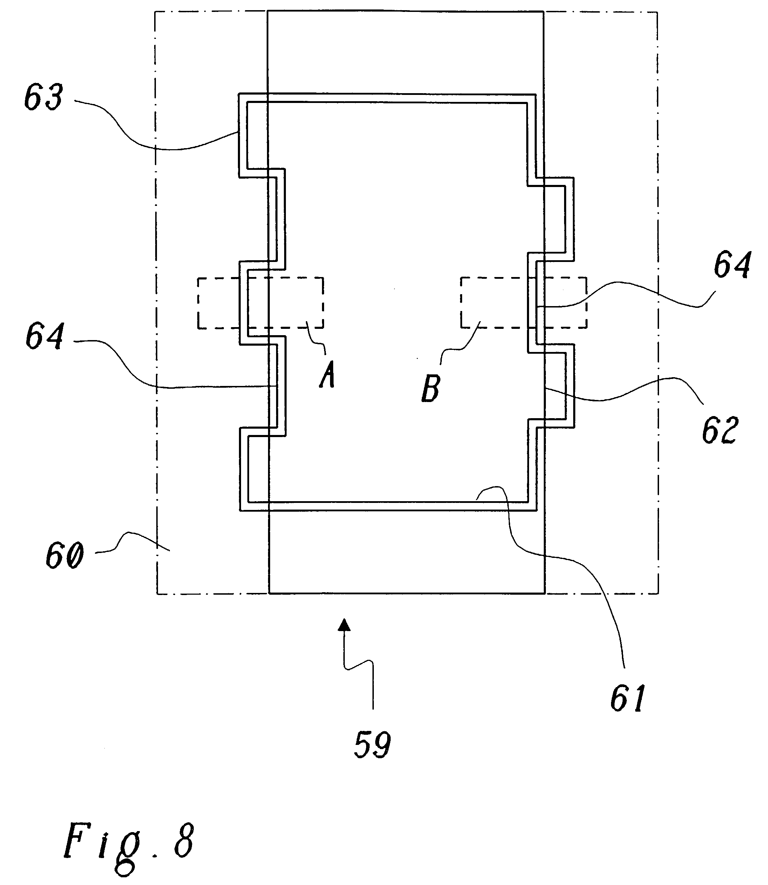

Ein weiteres bevorzugtes Ausführungsbeispiel des Verfahrens nach der Erfindung kann an der in Fig. 8 dargestellten Geometrie der fertigen Bauelementzelle 59 erläutert werden: Bei dieser Bauelementzelle 59 hat die Maske 62 für das Emittergebiet eine einfache rechteckige Oeffnung, so dass das Emittergebiet (wie in Fig. 7(a)) einfach streifenförmig ist. Die Maske 63 für die Gateelektrode und damit die Gateelektrode 60 selbst hat nicht - wie in den Fällen der Figuren 6 und 7 - gerade durchgehende Längskanten, sondern die Maske 63 weist Finger 64 auf. Diesen Fingern 64 entsprechen Finger an der Gateelektrode 60, die über den Rand des Emittergebiets (Maske 62) nach innen reichen. Diese Strukturierung der Gateelektrode 60 resultiert beim Implantieren von Kanalgebiet und Sourcegebiet (siehe Fig. 6(e,f) oder Fig. 7 (e,f) in der gewünschten strukturierten MOS-Kanal-Struktur: Im Gebiet A (ausserhalb der Finger 64) entsteht eine normale MOS-Steuerstruktur, im Gebiet B (innerhalb der Finger 64) wird die Bildung eines Kanals dadurch verhindert, dass das implantierte N⁺-Sourcegebiet vollständig innerhalb des P⁺-Emittergebietes (Maske 62) liegt. Auch hier kann wieder durch Anzahl (Wiederholrate) und Breite der Finger 64 die wirksame Kanalweite auf einfache Weise eingestellt werden. Die Maske 61 für das Emitterkontaktgebiet kann vorzugsweise - wie in Fig. 8 angedeutet - in der Kontur der Maske 63 folgen, so dass kein zusätzlicher Emitter-Ballast-Widerstand entsteht.

Insgesamt lässt sich mit dem erfindungsgemässen Verfahren ein MOS-gesteuertes Leistungshalbleiterbauelement herstellen, welches hinsichtlich der Leistungsdichte im Kurzschlussfall und des Löcher-Bypass-Widerstandes optimiert ist, ohne bei der Herstellung zusätzliche Maskenschritte zu erfordern.

### BEZEICHNUNGSLISTE

- 1,12: Leistungshalbleiterbauelement (MOS-gesteuert)
- 2,13: Substrat
- 3,14: Basisgebiet
- 4,15: Kollektorgebiet (Anode)
- 5,16: Kollektormetallisierung
- 6,6',17: Emittergebiet
- 7,18: Kanalgebiet
- 8,8',22: Sourcegebiet
- 9,9',19: Gateelektrode
- 10,20: Oxid
- 11,24: Emitterkontakt
- 21: Fenster
- 23: Kontaktloch
- 25: Maske
- 26: Maskenöffnung
- 27: Gatebereich
- 28: Emittergebiet
- 29: Sourcegebiet (strukturiert)
- 30,45: Leistungshalbleiterbauelement (MOS-gesteuert)
- 31,46: Substrat
- 32,47: Basisgebiet
- 33,48: Kollektorgebiet (Anode)
- 34: Maske (Emittergebiet)
- 35: Maskenöffnung
- 36: Aussparung
- 37,49: Emittergebiet
- 38: Finger (Emittergebiet)
- 39,54: Gateelektrode
- 40,55: Oxid
- 41,65: Fenster
- 42,56: Kanalgebiet
- 43,57: Sourcegebiet
- 44: Kontaktloch
- 50: Maske (Feldoxid)
- 51,53: Finger
- 52: Feldoxidschicht
- 58: Kontaktloch
- 59: Bauelementzelle
- 60: Gateelektrode
- 61: Maske (Emitterkontaktgebiet)
- 62: Maske (Emittergebiet)
- 63: Maske (Gateelektrode)
- 64: Finger (Gateelektroden-Maske)

## Patentansprüche

1. Verfahren zum Herstellen eines MOS-gesteuerten Leistungshalbleiterbauelements (30, 45), welches Leistungshalbleiterbauelement (30, 45) in einem gemeinsamen Substrat (31, 46) eine Mehrzahl von nebeneinander angeordneten, parallelgeschalteten Bauelementzellen (59) umfasst, wobei in jeder Bauelementzelle (59) ein aus einem Kollektorgebiet (33, 48) eines ersten Leitfähigkeitstyps, einem darüberliegenden Basisgebiet (32, 47) eines zweiten Leitfähigkeitstyps, und einem von oben in das Basisgebiet (32, 47) eingelassenen Emittergebiet (37, 49) vom ersten Leitfähigkeitstyp gebildeter Bipolartransistor vorhanden ist, und wobei auf der Emitterseite eine MOS-Kanal-Struktur (39, 42, 43 bzw. 54, 56, 57) zur Steuerung des Bipolartransistors vorgesehen ist, welche MOS-Kanal-Struktur (39, 42, 43 bzw. 54, 56, 57) ein oberhalb des Emittergebietes (37, 49) liegendes Sourcegebiet (43, 57) vom zweiten Leitfähigkeitstyp, ein randseitig am Emittergebiet (37, 49) zwischen Sourcegebiet (43, 57) und Basisgebiet (32, 47) angeordnetes Kanalgebiet (42, 56) vom ersten Leitfähigkeitstyp und eine über dem Kanalgebiet (42, 56) isoliert angeordnete Gateelektrode (39, 54) umfasst, dadurch gekennzeichnet, dass die MOS-Kanal-Struktur (39, 42, 43 bzw. 54, 56, 57) in der Kanalweite strukturiert ist, und dass die Strukturierung der Kanalweite der MOS-Kanal-Struktur (39, 42, 43 bzw. 54, 56, 57) indirekt durch einen der anderen im Herstellungsprozess des Bauelements verwendeten Maskenschritte erfolgt.

2. Verfahren nach Anspruch 1, dadurch gekennzeichnet, dass zur Strukturierung der Kanalweite der MOS-Kanal-Struktur (39, 42, 43) derjenige Maskenschritt verwendet wird, mit welchem das Emittergebiet (37) in das Substrat (31) eingebracht wird.

3. Verfahren nach Anspruch 2, dadurch gekennzeichnet, dass für den Maskenschritt, mit welchem das Emittergebiet (37) in das Substrat (31) eingebracht wird, eine Maske (34) verwendet wird, welche randseitig um eine Maskenöffnung (35) herum angeordnete, seitlich nach aussen sich erstreckende Aussparungen (36) aufweist, derart, dass das eingebrachte Emittergebiet (37) im Gebiet der Aussparungen (36) seitlich nach aussen sich erstreckende Finger (38) aufweist, und dass die Länge der Finger (38) so gewählt wird, dass sie zumindest über das später eingebrachte Sourcegebiet (43) seitlich hinausragen.

4. Verfahren nach Anspruch 3, dadurch gekennzeichnet, dass die Länge der Finger (38) so gewählt wird, dass sie über das später eingebrachte, an das Sourcegebiet (43) seitlich angrenzende Kanalgebiet (42) seitlich hinausragen.

5. Verfahren nach einem der Ansprüche 3 und 4, dadurch gekennzeichnet, dass die Kanalweite der MOS-Kanal-Struktur (39, 42, 43) durch Anzahl und Breite der Finger (38) eingestellt wird.

6. Verfahren nach Anspruch 1, dadurch gekennzeichnet, dass auf der Oberseite des Substrats (46) zwischen den Bauelementzellen eine Feldoxidschicht (52) angeordnet ist, und dass zur Strukturierung der Kanalweite der MOS-Kanal-Struktur (54, 56, 57) derjenige Maskenschritt verwendet wird, mit welchem die Feldoxidschicht (52) auf dem Substrat (46) strukturiert wird.

7. Verfahren nach Anspruch 6, dadurch gekennzeichnet, dass für den Maskenschritt, mit welchem die Feldoxidschicht (52) auf dem Substrat (46) strukturiert wird, eine Maske (50) verwendet wird, welche vom Rand des die Bauelementzelle umgebenden Maskengebiets ausgehende und nach innen sich erstreckende erste Finger (51) aufweist, derart, dass die aufgebrachte Feldoxidschicht (52), welche die Bauelementzellen umgibt, im Gebiet der ersten Finger (51) nach innen sich erstreckende zweite Finger (53) aufweist, welche bei dem nachfolgenden Einbringen des Sourcegebietes (57) eine Ausbildung des Sourcegebietes in ihrem Bereich verhindern bzw. maskieren.

8. Verfahren nach Anspruch 7, dadurch gekennzeichnet, dass die Kanalweite der MOS-Kanal-Struktur (54, 56, 57) durch Anzahl und Breite der zweiten Finger (53) eingestellt wird.

9. Verfahren nach Anspruch 1, dadurch gekennzeichnet, dass zur Strukturierung der Kanalweite der MOS-Kanal-Struktur derjenige Maskenschritt verwendet wird, mit welchem die Gateelektrode (60) auf dem Substrat strukturiert wird.

10. Verfahren nach Anspruch 9, dadurch gekennzeichnet, dass für den Maskenschritt, mit welchem die Gateelektrode (60) auf dem Substrat strukturiert wird, eine Maske (63) verwendet wird, welche vom Rand des die Bauelementzelle umgebenden Maskengebiets ausgehende und nach innen sich erstreckende erste Finger (64) aufweist, derart, dass die aufgebrachte Gateelektrode (60) im Gebiet der Aussparungen (64) nach innen sich erstreckende zweite Finger aufweist, welche bei dem nachfolgenden Einbringen des Sourcegebietes die Ausbildung einer Kanalstruktur in ihrem Bereich verhindern bzw. maskieren.

11. Verfahren nach Anspruch 10, dadurch gekennzeichnet, dass die Kanalweite der MOS-Kanal-Struktur durch Anzahl und Breite der zweiten Finger eingestellt wird.
